# EUROPEAN PATENT APPLICATION

(11) **EP 4 557 898 A1**
(43) Date of publication of application: **21.05.2025**
(21) Application number: 23839688.1
(22) Date of filing: 13.07.2023
(51) Int. Cl.: H05K 5/06, F16K 24/00

(54) **VENTILATION COMPONENT AND VENTILATION STRUCTURE**

(30) Priority: 13.07.2022 JP 2022112778
(71) Applicant: NITTO DENKO CORPORATION, Ibaraki-shi Osaka 567-8680 (JP)
(72) Inventor: TAKAHASHI Takumi, Ibaraki-shi, Osaka 567-8680 (JP); YANO Youzou, Ibaraki-shi, Osaka 567-8680 (JP); UCHIDA Hiromu, Ibaraki-shi, Osaka 567-8680 (JP)
(74) Representative: Müller-Boré & Partner Patentanwälte PartG mbB
(86) International application number: PCT/JP2023/025940
(87) International publication number: WO 2024/014516

(57) **Abstract**

A ventilation component 1a includes an internal member 10, a gas-permeable membrane 20, and an external member 30. The internal member 10 includes an elastic material and has an open tubular structure. The gas-permeable membrane 20 covers one opening 13 of the internal member 10. The external member 30 has a closed tubular structure. The internal member 10 is fixed to the external member 30 to form a first contact portion 5c with a portion of an inner circumferential surface of the external member 30. The first contact portion 5c is placed between a center C₁₀ and the one opening 13. An inner diameter of the external member 30 is larger than an outer diameter of the internal member 10 between the first contact portion 5c and the other opening 14. The external member 30 includes the protruding portion 31p forming the first contact portion 5c. A gap 30g is present by the protruding portion 31p.

## Description

### TECHNICAL FIELD

The present invention relates to a ventilation component and a ventilation structure.

### BACKGROUND ART

Ventilation components are sometimes fixed to housings of in-vehicle electrical components such as lamps, inverters, converters, electronic control units (ECUs), battery packs, radars, and cameras and a variety of electronic devices for home use, medical use, office use, etc. For example, ventilation components can sometimes be fixed to a housing, for example, to ensure ventilation between the inside and the outside of the housing or to reduce pressure variation inside the housing. Ventilation components to be fixed to a housing are required to have, in addition to ventilation properties, various properties such as dust proofness for preventing entry of dust into the housing, water proofness for preventing entry of water into the housing, oil proofness for preventing entry of oil into the housing, and CCT resistance for preventing entry of salt into the housing depending on a specific use of the housing.

For example, Patent Literature 1 describes a ventilation component capable of being fixed to a projection of a housing. This ventilation component includes an internal member, a gas-permeable membrane, and an external member. The internal member has a protruding portion protruding outward from an outer circumferential surface thereof. The external member has a hooking portion hooking a protruding portion. When the internal member and the external member are viewed in plan along an axis of the ventilation component, an outer diameter O_{B} of the protruding portion, an inner diameter I_{H} of the hooking portion, and an inner diameter O_{O} of a portion of the external member satisfy a requirement I_{H} < O_{B} < O_{O}, the portion facing the protruding portion. It is described that this ventilation component is advantageous in eliminating a disadvantage associated with deformation of the internal member caused to deform by the projection of the housing at the time of fixing the ventilation component to the projection of the housing.

### CITATION LIST

### Patent Literature

Patent Literature 1: WO 2021/145383 A1

### SUMMARY OF INVENTION

### Technical Problem

The ventilation component of Patent Literature 1 leaves room for reexamination from the perspective of preventing the ventilation component from moving away from the projection after attached to the projection of the housing.

Therefore, the present invention provides a ventilation component advantageous in that the ventilation component is prevented from moving away from a projection of a housing after attached to the projection.

### Solution to Problem

The present invention provides a ventilation component including:
an internal member including an elastic material and having an open tubular structure;
a gas-permeable membrane covering one opening of the internal member; and
an external member having a closed tubular structure, wherein
the internal member is fixed to the external member such that the internal member is inserted inside the external member and that a portion of an outer circumferential surface of the internal member is elastically deformed to form a first contact portion with a portion of an inner circumferential surface of the external member,
the ventilation component is capable of being fixed to a projection of a housing such that the projection is inserted inside the internal member through the other opening of the internal member and that an inner circumferential surface of the internal member is elastically deformed to form a second contact portion with an outer circumferential surface of the projection, the projection tubularly protruding from an outer surface of the housing toward an edge of a ventilation opening allowing communication between an inner space of the housing and an outer space of the housing,
the first contact portion is placed between a center of a portion of the internal member and the one opening, the center being defined in an axial direction of the internal member, the portion overlapping the external member in the axial direction,
an inner diameter of the external member is larger than an outer diameter of the internal member between the first contact portion and the other opening in the axial direction of the internal member,
a combination of the internal member and the external member includes a protruding portion arranged on the inner circumferential surface of the external member or the outer circumferential surface of the internal member, the protruding portion forming the first contact portion, and
around an axis of the internal member, a gap is present by the protruding portion and between the inner circumferential surface of the external member and the outer circumferential surface of the internal member.

The present invention also provides a ventilation structure including:
a housing;
an internal member including an elastic material and having an open tubular structure;
a gas-permeable membrane covering one opening of the internal member; and
an external member having a closed tubular structure, wherein
the internal member is fixed to the external member such that the internal member is inserted inside the external member and that a portion of an outer circumferential surface of the internal member is elastically deformed to form a first contact portion with a portion of an inner circumferential surface of the external member,
the housing includes a projection tubularly protruding from an outer surface of the housing toward an edge of a ventilation opening allowing communication between an inner space of the housing and an outer space of the housing,
the internal member is fixed to the projection such that the projection is inserted inside the internal member through the other opening of the internal member and that an inner circumferential surface of the internal member is elastically deformed to form a second contact portion with an outer circumferential surface of the projection,
the first contact portion is placed between a center of a portion of the internal member and the one opening, the center being defined in an axial direction of the internal member, the portion overlapping the external member in the axial direction,
an inner diameter of the external member is larger than an outer diameter of the internal member between the first contact portion and the other opening in the axial direction of the internal member,
a combination of the internal member and the external member includes a protruding portion arranged on the inner circumferential surface of the external member or the outer circumferential surface of the internal member, the protruding portion forming the first contact portion, and
around an axis of the internal member, a gap is present by the protruding portion and between the inner circumferential surface of the external member and the outer circumferential surface of the internal member.

### Advantageous Effects of Invention

The above ventilation component is advantageous in that the ventilation component is prevented from moving away from the projection of the housing after attached to the projection.

### BRIEF DESCRIPTION OF DRAWINGS

FIG. 1A is a plan view showing a ventilation component according to the present invention.
FIG. 1B is a side view of the ventilation component shown in FIG. 1A.
FIG. 1C is a side view of the ventilation component viewed in a direction of an arrow C shown in FIG. 1A.
FIG. 2A is a cross-sectional view of the ventilation component along a line A-A shown in FIG. 1A as a cutting plane line.
FIG. 2B is a cross-sectional view of the ventilation component along a line B-B shown in FIG. 1A as a cutting plane line.
FIG. 3 is a cross-sectional view of the ventilation component along a line III-III shown in FIG. 2A as a cutting plane line.
FIG. 4 is a cross-sectional view of an example of a ventilation structure including the ventilation component shown in FIG. 1A.
FIG. 5 is a cross-sectional perspective view schematically showing a force acting when a ventilation component according to a reference example is attached to a projection of a housing.
FIG. 6A is a cross-sectional view of another example of the ventilation component according to the present invention.
FIG. 6B is a cross-sectional view of yet another example of the ventilation component according to the present invention.
FIG. 6C is a cross-sectional view of yet another example of the ventilation component according to the present invention.
FIG. 6D is a cross-sectional view of yet another example of the ventilation component according to the present invention.
FIG. 6E is a cross-sectional view of yet another example of the ventilation component according to the present invention.
FIG. 6F is a cross-sectional view of yet another example of the ventilation component according to the present invention.
FIG. 6G is a cross-sectional view of yet another example of the ventilation component according to the present invention.
FIG. 7A is a cross-sectional view of yet another example of the ventilation component according to the present invention.
FIG. 7B is a cross-sectional view of the ventilation component along a line VIIB-VIIB shown in FIG. 7A as a cutting plane line.
FIG. 7C is a cross-sectional view of yet another example of the ventilation component according to the present invention.
FIG. 7D is a cross-sectional view of yet another example of the ventilation component according to the present invention.
FIG. 8A is a cross-sectional view of yet another example of the ventilation component according to the present invention.
FIG. 8B is a cross-sectional view of the ventilation component along a line VIIIB-VIIIB shown in FIG. 8A as a cutting plane line.
FIG. 8C is a cross-sectional view of yet another example of the ventilation component according to the present invention.
FIG. 9 is a graph showing a relation between an average of amounts of change for ventilation structures according to Example 1 and Comparative Example 1 and a test time.
FIG. 10 is a graph showing a relation between an average of amounts of change for ventilation structures according to Example 2 and Comparative Example 2 and a test time.

### DESCRIPTION OF EMBODIMENTS

Hereinafter, embodiments of the present invention will be described with reference to the drawings. The present invention is not limited to the following embodiments.

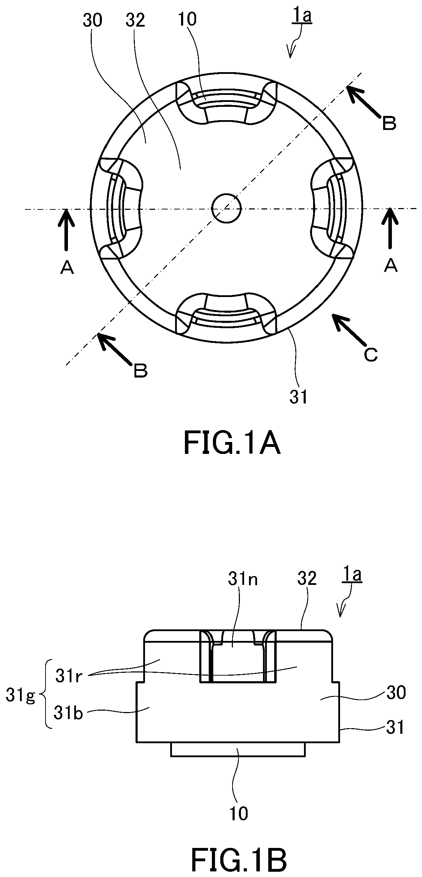

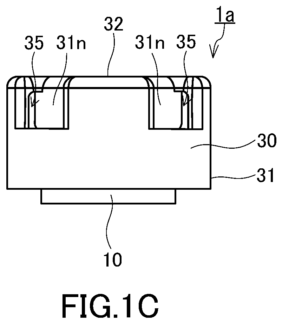

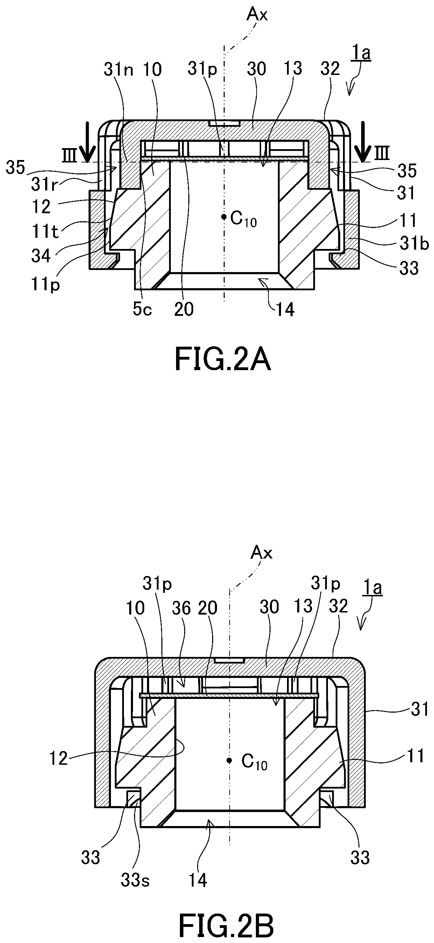

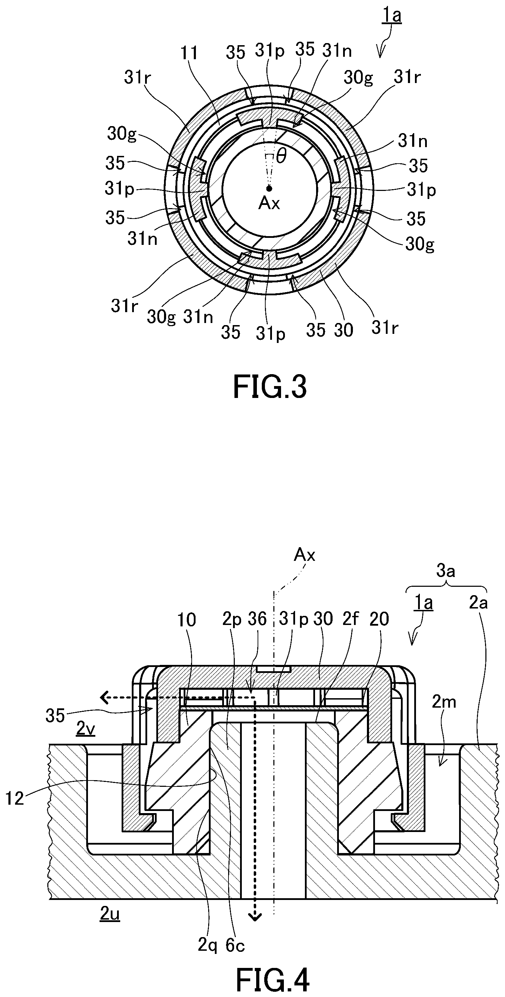

As shown in FIGS. 1A, 1B, 1C, 2A, and 2B, a ventilation component 1a includes an internal member 10, a gas-permeable membrane 20, and an external member 30. The internal member 10 includes an elastic material, and has an open tubular structure. In other words, the internal member 10 is formed in the shape of a tube having an opening at each end thereof. The gas-permeable membrane 20 covers one opening 13 of the internal member 10. The external member 30 has a closed tubular structure. In other words, the external member 30 is formed in the shape of a tube having an opening at only one of two ends. The internal member 10 is fixed to the external member 30 such that the internal member 10 is inserted inside the external member 30 and that a portion of an outer circumferential surface of the internal member 10 is elastically deformed to form a first contact portion 5c with a portion of an inner circumferential surface of the external member 30. The first contact portion 5c is arranged between a center C₁₀ and the one opening 13 in an axial direction of the internal member 10. The center C₁₀ is a center of a portion of the internal member 10, the center being defined in the axial direction of the internal member 10, the portion overlapping the external member 30 in the axial direction. An inner diameter of the external member 30 is larger than an outer diameter of the internal member 10 between the first contact portion 5c and the other opening 14 in the axial direction of the internal member 10. As shown in FIG. 3, the external member 30 includes a protruding portion 31p forming the first contact portion 5c. The protruding portion 31p is arranged on the inner circumferential surface of the external member 30. Around the axis of the internal member 10, a gap 30g is present by the protruding portion 31p and between the inner circumferential surface of the external member 30 and the outer circumferential surface of the internal member 10.

As shown in FIG. 4, the ventilation component 1a is capable of being fixed to a projection 2p of a housing 2a such that the projection 2p is inserted inside the internal member 10 through the other opening 14 of the internal member 10 and that an inner circumferential surface 12 of the internal member 10 is elastically deformed to form a second contact portion 6c with an outer circumferential surface 2q of the projection 2p. By fixing the ventilation component 1a to the projection 2p in this manner, a ventilation structure 3a is provided. The projection 2p tubularly protrudes from an outer surface of the housing toward an edge 2f of a ventilation opening allowing communication between an inner space 2u of the housing 2a and an outer space 2v of the housing 2a.

For the ventilation component 1a, since the internal member 10 is fixed to the external member 30 to form the first contact portion 5c, an axis Ax of the internal member 10 is unlikely to be oblique to an axis of the external member 30. The ventilation component 1a is attached to the projection 2p of the housing 2a, for example, with the external member 30 grasped. If the internal member 10 were not fixed to the external member 30 to form the first contact portion 5c, the axis Ax of the internal member 10 would be oblique to the axis of the external member 30 and the ventilation component 1a would not be able to be appropriately attached to the projection 2p of the housing 2a. For the ventilation component 1a, since the internal member 10 is fixed to the external member 30 to form the first contact portion 5c, such a trouble is less likely to happen and the ventilation component 1a is easily attached to the projection 2p of the housing 2a in a desired state.

For example, when the internal member 10 yet to be fixed to the external member 30 in a direction parallel to the axis Ax of the internal member 10 is viewed in plan, a diameter D₁₀ of a circumscribed circle circumscribed around a portion of the internal member 10 is larger than a diameter D₃₀ of an inscribed circle inscribed in a portion of the external member 30, the portions each forming the first contact portion 5c. Because of this, in the ventilation component 1a, the first contact portion 5c can be formed in a desired state. A ratio D₁₀/D₃₀ of the diameter D₁₀ to the diameter D₃₀ is not limited to a particular value. The ratio D₁₀/D₃₀ is, for example, 1.01 to 1.3, and may be 1.05 to 1.2, or 1.05 to 1.1.

As described above, in the ventilation component 1a, the inner diameter of the external member 30 is larger than the outer diameter of the internal member 10 between the first contact portion 5c and the other opening 14 in the axial direction of the internal member 10, and a gap 34 is present there. For example, the projection 2p is inserted into the internal member 10 to fix the ventilation component 1a to the projection 2p. An outer diameter of the projection 2p is larger than the inner diameter of the internal member 10. Since including the elastic material, the internal member 10 is deformed at this time by the projection 2p to have an increased inner diameter. This deformation induces an increase in the outer diameter of the internal member 10 too. If the inner diameter of the external member 30 were equal to or less than the outer diameter of the internal member 10 between the first contact portion 5c and the other opening 14 in the axial direction of the internal member 10, the internal member 10 would be subjected to a large compressive stress between the projection 2p and the external member 30. Hence, a large force would be needed to insert the projection 2p inside the internal member 10. However, in the ventilation component 1a, since the inner diameter of the external member 30 is larger than the outer diameter of the internal member 10 between the first contact portion 5c and the other opening 14 in the axial direction of the internal member 10, a portion of the internal member 10 deformed enters the gap 34 in inserting the projection 2p into the internal member 10. Consequently, the internal member 10 is not likely to be subjected to a large compressive stress between the projection 2p and the external member 30, and a force needed to insert the projection 2p inside the internal member 10 is easily reduced.

Between the first contact portion 5c and the other opening 14 in the axial direction of the internal member 10, a difference ΔD determined by subtracting the outer diameter of the internal member 10 from the inner diameter of the external member 30 is not limited to a particular value. The difference ΔD is, for example, 0.1 mm or more and 1.0 mm or less. This more easily eliminates the disadvantage associated with deformation of the internal member 10 at the time of fixing the ventilation component 1a to the tubular projection 2p of the housing 2a.

The difference ΔD may be 0.2 mm or more, or 0.3 mm or more. The difference ΔD may be 0.9 mm or less, or 0.8 mm or less.

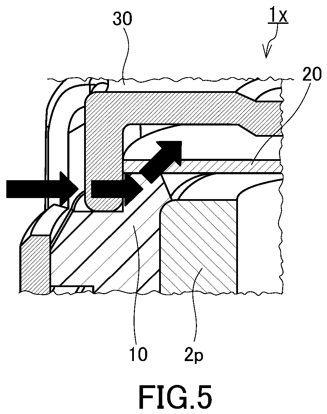

FIG. 5 is a cross-sectional perspective view schematically showing a force acting when a ventilation component 1x according to Reference Example is attached to the projection 2p of the housing 2a. The ventilation component 1x is configured in the same manner as the ventilation component 1a, except for the absence of the protruding portion 31p. In attaching the ventilation component 1x to the projection 2p, the internal member 10 is deformed by the projection 2p to increase the inner diameter of the internal member 10. This deformation induces an increase in the outer diameter of the internal member 10, and also deforms a portion of the internal member 10 outward in the direction perpendicular to the axis Ax, the portion forming the first contact portion 5c. When a rigidity of the external member 30 is higher than that of the internal member 10, the external member 30 pushes a portion of the internal member 10 to prevent the portion of the internal member 10 from deforming outward in the direction perpendicular to the axis Ax, the portion forming the first contact portion 5c. A compressive force exerted by the external member 30 to push a portion of the internal member 10 creates a force to tightly hold the projection 2p, the portion forming the first contact portion 5c. When the first contact portion 5c is placed between the center C₁₀ and the one opening 13, a force to push up the internal member 10 is likely to act near a top end of the projection 2p and the ventilation component 1x might move away from the projection 2p after attached to the projection 2p.

On the other hand, in the ventilation component 1a, as shown in FIG. 3, the external member 30 includes the protruding portion 31p forming the first contact portion 5c, and the gap 30g is present by the protruding portion 31p. Because of this configuration, when the internal member 10 is deformed by the projection 2p to increase the inner diameter of the internal member 10 in attaching the ventilation component 1a to the projection 2p, the deformed portion enters the gap 30g and the compressive force exerted by the external member 30 to push a portion of the internal member 10 is reduced, the portion forming the first contact portion 5c. Consequently, a force to push up the internal member 10 is less likely to act near the top end of the projection 2p, and the ventilation component 1a is easily prevented from moving away from the projection 2p after attached to the projection 2p.

A dimension of the protruding portion 31p around the axis Ax of the internal member 10 is not limited to a particular value. For example, on a plane perpendicular to the axis Ax of the internal member 10, a pair of straight lines connecting each of two ends of the protruding portion 31p and the axis Ax of the internal member 10 makes an angle θ of 20° or smaller, the ends being defined around the axis Ax. This configuration further reduces the compressive force exerted by the external member 30 to push a portion of the internal member 10, and more easily prevents the ventilation component 1x from moving away from the projection 2p after the ventilation component 1x is attached to the projection 2p, the portion forming the first contact portion 5c. The angle θ may be 15° or smaller, or 10° or smaller. The angle θ is, for example, 5° or more.

The external member 30 includes, for example, a plurality of the protruding portions 31p. The protruding portions 31p are placed, for example, around the axis Ax at regular intervals. In the case of this configuration, in the ventilation component 1a, the axis of the external member 30 is likely to be parallel to the axis Ax of the internal member 10, and the ventilation component 1a is easily attached to the projection 2p of the housing 2a in a desired state in attaching the ventilation component 1a to the projection 2p of the housing 2a with the external member 30 grasped.

A shape of the protruding portion 31p is not limited to a particular shape. The protruding portion 31p has, for example, a rectangular outline in a cross-sectional view showing a cross section which is a plane perpendicular to the axis Ax of the internal member 10. In the case of this configuration, the external member 30 is easily produced by molding.

As shown in FIG. 2A, the closed tubular structure of the external member 30 has a side wall 31 and a bottom wall 32. The side wall 31 extends along the axis Ax. The bottom wall 32 extends in a direction perpendicular to the axis Ax. The bottom wall 32 and the side wall 31 meet to form a corner.

The gas-permeable membrane 20 is typically covered by the bottom wall 32. The bottom wall 32 is, for example, placed apart from the gas-permeable membrane 20 in the axial direction of the ventilation component 1a. Consequently, a space 36 is formed between the bottom wall 32 and the gas-permeable membrane 20. A gas passes through the space 36 for ventilation.

As shown in FIG. 2A and FIG. 2B, the internal member 10 includes, for example, a central protruding portion 11. The central protruding portion 11 is arranged on the outer circumferential surface of the internal member 10 at a position closer to the other opening 14 than the first contact portion 5c in the axial direction of the internal member 10. The central protruding portion 11 protrudes toward in the direction perpendicular to the axis Ax of the internal member 10. In the case of this configuration, a boundary between a portion of the internal member 10 and another portion thereof is easily defined, the portion forming the first contact portion 5c.

As shown in FIGS. 2A, 2B, and 3, the external member 30 includes a protection wall 31n. The protection wall 31n extends in the direction parallel to the axis Ax at a portion closer to the axis Ax than an outermost edge of the external member 30 when the external member 30 is viewed in plan along the axis Ax of the internal member 10, the outermost edge being defined in the direction perpendicular to the axis Ax. The protection wall 31n protects the first contact portion 5c. In the case of this configuration, the first contact portion 5c is likely to be protected by the protection wall 31n and be kept in a desired state.

The protection wall 31n overlaps the central protruding portion 11, for example, in the direction perpendicular to the axis Ax. In the case of this configuration, the protection wall 31n determines the positions of the internal member 10 and the external member 30 in the axial direction. Thereby, for example, the distance between the bottom wall 32 of the external member 30 and the gas-permeable membrane 20 can be adjusted to a desirable value. As shown in FIG. 2A, for example, an end of the protection wall 31n faces the central protruding portion 11 of the internal member 10, the end being defined in the axial direction.

The protection wall 31n has, for example, an arc-shaped outline in plan view. The protruding portion 31p is formed, for example, integrally with the protection wall 31n, and is placed at a center of the protection wall 31n around the axis Ax of the internal member 10.

The external member 30 includes, for example, a plurality of the protection walls 31n corresponding to the plurality of protruding portions 31p. The protection walls 31n are placed, for example, around the axis Ax at given intervals.

As shown in FIG. 3, the central protruding portion 11 extends along the entire outer circumference of the open tubular structure of the internal member 10. In other words, the central protruding portion 11 is arranged, for example, in a ring shape. In the case of this configuration, a boundary between a portion of the internal member 10 and another portion thereof is easily defined in the internal member 10, regardless of how the internal member 10 is placed around the axis Ax, the portion forming the first contact portion 5c.

As shown in FIGS. 2A and 2B, the external member 30 includes, for example, a hooking portion 33. The hooking portion 33 is arranged on the inner circumferential surface of the external member 30, and hooks the central protruding portion 11. This prevents the external member 30 of the ventilation component 1a from slipping off the internal member 10.

As shown in FIG. 2A, the hooking portion 33 protrudes, for example, toward the axis Ax in the direction perpendicular to the axis Ax. The external member 30 includes, for example, a plurality of the hooking portions 33. The hooking portions 33 are, for example, placed around the axis Ax at given intervals. The hooking portions 33 are, for example, placed around the axis Ax at regular intervals. The hooking portion 33 may be arranged, for example, in a ring shape on the inner circumferential surface of the closed tubular structure of the external member 30.

As shown in FIG. 2B, the hooking portion 33 has, for example, a slope 33s. The distance between the slope 33s and the outer circumferential surface of the internal member 10 at a particular position in the axial direction is greater than the distance between the slope 33s and the outer circumferential surface of the internal member 10 at a position closer, in the axial direction, to the central protruding portion 11 than the particular position. This configuration is likely to decrease a friction force between the central protruding portion 11 and the hooking portion 33 at the time of attaching the internal member 10 to the inside of the external member 30. Therefore, the internal member 10 is easily attached to the inside of the external member 30.

As shown in FIG. 2A, an end surface of the central protruding portion 11 in the direction perpendicular to the axis Ax includes, for example, a taper surface 11t and a cylindrical surface 11p. The cylindrical surface 11p is arranged closer to the other opening 14 than the taper surface 11t. A diameter of the taper surface 11t decreases toward the one opening 13. A ratio (Lt/Lz) of a length Lt of a portion forming the taper surface 11t to a whole length Lz of the protruding portion 11 in the axial direction is, for example, 0.2 to 0.8. For example, the internal member 10 is attached to the inside of the external member 30 by relatively moving the internal member 10 and the external member 30 so that the distance between the external member 30 and the internal member 10 in the axial direction will decrease. At this time, a portion of the external member 30 near the hooking portion 33 deforms outward in the direction perpendicular to the axis Ax. The ratio Lt/Lz in the above range makes it unlikely that the amount of deformation of the portion near the hooking portion 33 varies rapidly in attaching the internal member 10 to the inside of the external member 30. Therefore, the internal member 10 is easily attached to the inside of the external member 30. Moreover, the ratio Lt/Lz in the above range is likely to shorten the length of the cylindrical surface 11p in the axial direction, and thus a duration in which the amount of deformation of the portion near the hooking portion 33 is maximum is easily shortened in attaching the internal member 10 to the inside of the external member 30.

As shown in FIGS. 1C and 2A, the ventilation component 1a has, for example, a ventilation hole 35. The ventilation hole 35 overlaps, for example, at least a portion of the first contact portion 5c in the axial direction of the internal member 10. This configuration allows ventilation through the ventilation hole 35 even when a ventilation path between the outer circumferential surface of the internal member 10 and the inner circumferential surface of the external member 30 is not wide between the first contact portion 5c and the other opening 14 in the axial direction of the internal member 10.

The ventilation hole 35 is formed, for example, through the side wall 31. In other words, the ventilation hole 35 connects an inner circumferential surface of the side wall 31 and an outer circumferential surface of the side wall 31. The ventilation hole 35 is formed, for example, at a position closer to the bottom wall 32 than the protruding portion 11 in the axial direction.

The ventilation hole 35 may be formed, for example, through the bottom wall 32. In other words, the ventilation hole 35 may be formed to connect an inner circumferential surface of the bottom wall 32 and an outer circumferential surface of the bottom wall 32. The ventilation hole 35 may be formed, for example, through the side wall 31 and the bottom wall 32. In other words, the ventilation hole 35 may be formed to connect the inner circumferential surface of the side wall 31 and the outer circumferential surface of the bottom wall 32, or may be formed to connect the inner circumferential surface of the bottom wall 32 and the outer circumferential surface of the side wall 31. The ventilation hole 35 may be formed as a through hole or may be formed as a slit.

As shown in FIG. 1C, the ventilation hole 35 is formed, for example, such that at least one of the internal member 10 and the gas-permeable membrane 20 is visually unrecognizable through the ventilation hole 35. In other words, the ventilation hole 35 is formed such that at least one of the internal member 10 and the gas-permeable membrane 20 is visually unrecognizable when the inside of the external member 30 is viewed from the outside of the external member 30 through the ventilation hole 35. In this case, for example, the inside of the external member 30 is observed in a direction perpendicular to an opening of the ventilation hole 35, the opening being in contact with the outer circumferential surface of the external member 30. Even if a foreign matter from the outside of the external member 30 passes through the ventilation hole 35, this configuration makes it easy to prevent the foreign matter from damaging at least one of the internal member 10 and the gas-permeable membrane 20.

As shown in FIGS. 1B and 3, the side wall 31 has, for example, an outer side wall 31g and the protection wall 31n. The outer side wall 31g includes, for example, a portion 31b of the external member 30 and a plurality of ribs 31r, the portion 31b facing the central protruding portion 11. The ribs 31r are placed around the axis Ax at given intervals between, in the axial direction, the portion 31b and the bottom wall 32. The ribs 31r are typically placed around the axis Ax at regular intervals. The protection wall 31n is placed at a position closer to the axis Ax than the outer side wall 31g in the direction perpendicular to the axis Ax. The protection wall 31n is arranged between, in the axial direction, the portion 31b and the bottom wall 32.

The ribs 31r and the protection walls 31n are, for example, alternately placed around the axis Ax. Consequently, the external member 30 has recesses formed around the axis Ax at given intervals, as shown in FIG. 1A. For example, around the axis Ax, an end portion of the rib 31r overlaps an end portion of the protection wall 31n. Consequently, a gap space between the end portion of the rib 31r and the end portion of the protection wall 31n around the axis Ax forms the ventilation hole 35. This configuration allows the side wall 31 to appropriately protect the internal member 10 and the gas-permeable membrane 20 and makes it easy to form a wide ventilation hole 35.

The elastic material included in the internal member 10 is not limited to a particular elastic material. The elastic material is, for example, an elastomer (elastic resin). The elastomer may be a rubber. Examples of the elastomer include nitrile rubber (NBR), ethylene-propylene rubber (EPDM), silicone rubber, fluorine rubber, acrylic rubber, hydrogenated rubber, and various thermoplastic elastomers.

The material of the external member 30 is not limited to a particular material. The material of the external member 30 is, for example, a resin. The resin is, for example, a thermoplastic resin or the above-described elastomer. Examples of the thermoplastic resin include polyamide (PA) such as nylon, polybutylene terephthalate (PBT), polyethylene terephthalate (PET), polyphenylene sulfide (PPS), polycarbonate (PC), polypropylene (PP), and polyphenylene ether (PPE). The material of the external member 30 may be a material same as the elastic material included in the internal member 10 or may be a material different from the elastic material included in the internal member 10.

The resins included in the internal member 10 and the external member 30 may include an additive such as: a pigment such as carbon black or titanium white; a reinforcing filler such as glass particles or glass fibers; or a water-repellent agent.

The gas-permeable membrane 20 is not limited to a particular gas-permeable membrane as long as the gas-permeable membrane 20 has desirable gas permeability. The gas-permeable membrane 20 may be a single layer membrane, or may be a multilayer membrane. In the case where the gas-permeable membrane 20 is a multilayer membrane, each layer thereof can be formed of one selected from the group consisting of a porous membrane, a nonwoven fabric, a cloth, and a mesh. The gas-permeable membrane 20 may include: a porous membrane and a nonwoven fabric; a porous membrane and at least one of a cloth and a mesh; or a plurality of nonwoven fabrics. Typically, the gas-permeable membrane 20 is composed of an organic polymer material (resin). The material of the porous membrane is, for example, a fluorine resin. As the fluorine resin can be used, for example, polytetrafluoroethylene (PTFE), polychlorotrifluoroethylene, a tetrafluoroethylene-hexafluoropropylene copolymer, or a tetrafluoroethylene-ethylene copolymer. The material of the porous membrane may be a polyolefin, such as a homopolymer or copolymer of a monomer(s) such as ethylene, propylene, or 4-methylpentene-1,1-butene. The porous membrane may be a porous nanofiber membrane made of, for example, polyacrylonitrile, nylon, or polylactic acid. The porous membrane can be manufactured by a known drawing or extraction technique. Examples of the materials of the nonwoven fabric, the cloth, and the mesh include polyesters such as polyethylene terephthalate, polyolefins such as polyethylene and polypropylene, nylon, aramids, and ethylene-vinyl acetate copolymer.

The gas-permeable membrane 20 desirably includes a porous PTFE membrane. The porous PTFE membrane can ensure gas permeability with a small area and can effectively prevent entry of a foreign matter. The porous PTFE membrane may be laid on a gas-permeable supporting member such as a nonwoven fabric.

The thickness of the gas-permeable membrane 20 is not limited to a particular thickness. The thickness of the gas-permeable membrane 20 is, for example, 1 µm or more and 5 mm or less. The gas permeation rate of the gas-permeable membrane 20 is 0.1 to 300 sec/100 mL, for example, when measured according to Method B (Gurley method) of gas permeability measurement specified in Japanese Industrial Standards (JIS) L 1096.

The gas-permeable membrane 20 may be subject to a liquid-repellant treatment as necessary. The liquid-repellant treatment is performed, for example, by forming a liquid-repellant coating film containing a fluorine surface modifier having a perfluoroalkyl group on the gas-permeable membrane 20. The method for forming the liquid-repellant coating film is not limited to a particular formation method. The liquid-repellant coating film is formed, for example, by coating a porous resin membrane with a solution or dispersion of a fluorine surface modifier having a perfluoroalkyl group by a method such as air spraying, electrostatic spraying, dip coating, spin coating, roll coating, curtain flow coating, or impregnation. The liquid-repellant coating film may be formed by electrodeposition or plasma polymerization.

A surface of at least one of the internal member 10 and the external member 30 may have at least partially been subjected to the liquid-repellent treatment. The liquid-repellent treatment can be performed, for example, by forming a coating film by any of the methods described above as the liquid-repellent treatment method for the gas-permeable membrane 20, electrodeposition coating, or plasma polymerization.

The gas-permeable membrane 20 is, for example, adhered to an end face of the internal member 10 in the axial direction. The gas-permeable membrane 20 may be welded to the end face. Available welding methods are thermal welding, ultrasonic welding, and laser welding. Alternately, at the time of molding the internal member 10, the gas-permeable membrane 20 may be attached to the end face by insert molding, specifically, by pouring a resin in a mold for molding the internal member 10 with the gas-permeable membrane 20 placed at a given position in the mold. The gas-permeable membrane 20 may be attached to the end face with a double-sided adhesive tape.

For example, the ventilation structure 3a shown in FIG. 4 can be provided using the ventilation component 1a. The ventilation structure 3a includes the ventilation component 1a and the housing 2a. The housing 2a has the tubular projection 2p on its outer circumferential surface, and the ventilation component 1a is fixed to the projection 2p. Specifically, the internal member 10 of the ventilation component 1a is fixed to the projection 2p in a specific state where the projection 2p is inserted inside the internal member 10 through the other opening 14 of the internal member 10 and the inner circumferential surface 12 of the internal member 10 and the outer circumferential surface 2q of the projection 2p abut each other. The inner diameter of the open tubular structure of the internal member 10 is smaller than the outer diameter of the projection 2p. Additionally, the inner circumferential surface 12 of the internal member 10 is typically formed of the elastic material. Because of this, in the specific state, a portion of the internal member 10 deforms to fit the outer diameter of the projection 2p, the portion abutting the outer circumferential surface 2q of the projection 2p. The ventilation component 1a is therefore firmly fixed to the projection 2p.

As shown in FIG. 4, according to the ventilation structure 3a, as indicated by a dashed arrow, a gas passes through the gas-permeable membrane 20 for ventilation between the inner space 2u and the outer space 2v of the housing 2a. For example, the space 36 and the ventilation hole 35 are included in the ventilation path for this ventilation.

As shown in FIG. 4, a groove 2m in a ring shape is formed around the projection 2p of the housing 2a. When the ventilation structure 3a is viewed in plan along the axis Ax, an outer diameter of the groove 2m is greater than an outer diameter of the ventilation component 1a. Because of this, when the ventilation component 1a is fixed to the projection 2p, a portion of the ventilation component 1a is housed in the groove 2m. This configuration can increase the area of a region in which the inner circumferential surface 12 of the internal member 10 and the outer circumferential surface 2q of the projection 2p abut each other and makes it likely that the ventilation component 1a is firmly fixed to the projection 2p. Additionally, an apparent protrusion length of the ventilation component 1a from the outer surface of the housing 2a can be reduced. In the housing 2a, the groove 2m does not need to be formed around the projection 2p.

The material of the housing 2a is not limited to a particular material. The material of the housing 2a is, for example, a resin, a metal, or a composite material thereof. The elastic modulus of the material of the projection 2p of the housing 2a is typically higher than the elastic modulus of the elastic material included in the internal member 20. Examples of the housing 2a include housings of in-vehicle electrical components such as lamps, inverters, converters, electronic control units (ECUs), battery packs, radars, and cameras. The housing 2a may be a housing of a variety of electronic devices for home use, medical use, office use, etc.

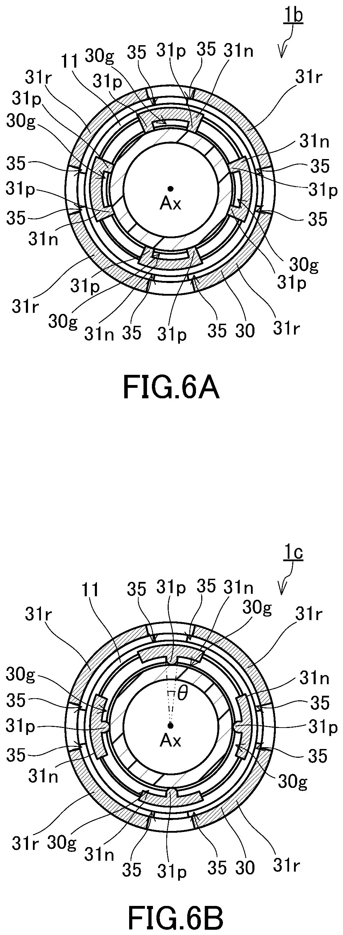

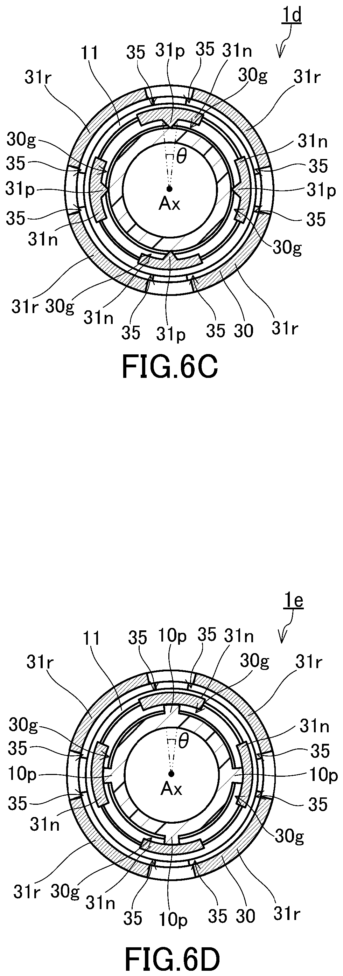

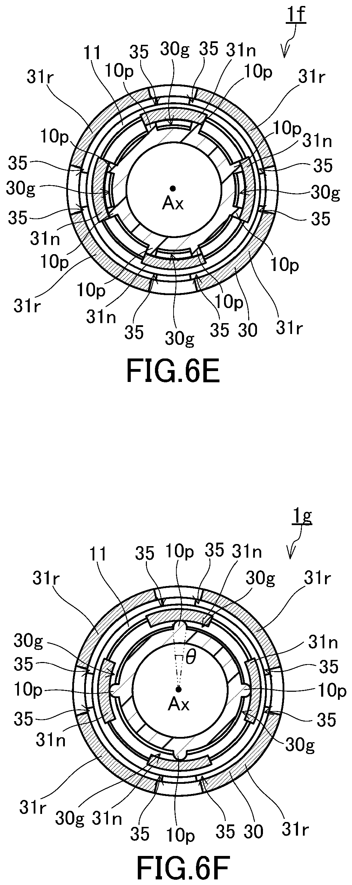

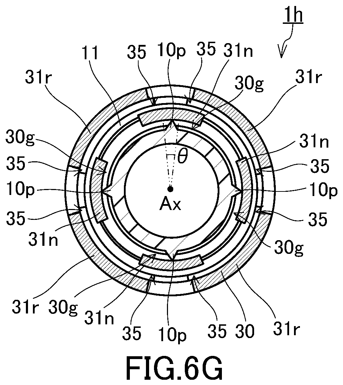

The ventilation component 1a can be modified in various respects. The ventilation component 1a may be modified to a ventilation component 1b shown in FIG. 6A, a ventilation component 1c shown in FIG. 6B, a ventilation component 1d shown in FIG. 6C, a ventilation component 1e shown in FIG. 6D, a ventilation component 1f shown in FIG. 6E, a ventilation component 1g shown in FIG. 6F, or a ventilation component 1h shown in FIG. 6G. The ventilation components 1b to 1h are configured in the same manner as the ventilation component 1a, unless otherwise described. The components of the ventilation components 1b to 1h that are the same as or correspond to those of the ventilation component 1a are denoted by the same reference characters, and detailed descriptions of such components are omitted. The description given for the ventilation component 1a can apply to the ventilation components 1b to 1h, unless there is technical inconsistency.

As shown in FIG. 6A, in the ventilation component 1b, a plurality of the protruding portions 31p is arranged on each protection wall 31n. For example, around the axis Ax, one protruding portion 31p is arranged on each end of the protection wall 31n. This configuration makes it even less likely that the axis Ax of the internal member 10 is oblique to the axis of the external member 30 and that the external member 30 slips off the internal member 10.

As shown in FIG. 6B, in the ventilation component 1c, the protruding portion 31p has, for example, a semicircular outline in a cross-sectional view showing a cross section which is a plane perpendicular to the axis Ax of the internal member 10. In the case of this configuration, the external member 30 is easily produced by molding.

As shown in FIG. 6C, in the ventilation component 1d, the protruding portion 31p has, for example, a triangular outline in a cross-sectional view showing a cross section which is a plane perpendicular to the axis Ax of the internal member 10. In this case as well, the external member 30 is easily produced by molding.

As shown in FIG. 6D, in the ventilation component 1e, the internal member 10 includes, instead of the protruding portion 31p, a protruding portion 10p forming the first contact portion 5c. The protruding portion 10p is arranged on the outer circumferential surface of the internal member 10. In the case of this configuration as well, the force to push up the internal member 10 is less likely to act near the top end of the projection 2p, and the ventilation component 1x is easily prevented from moving away from the projection 2p after attached to the projection 2p.

In the ventilation component 1e, the internal member 10 includes, for example, a plurality of the protruding portions 10p. The protruding portions 10p are placed, for example, around the axis Ax at regular intervals. The ventilation component 1e includes a plurality of the protection walls 31n. One protruding portion 10p is arranged for each protection wall 31n.

The protruding portion 10p has, for example, a rectangular outline in a cross-sectional view showing a cross section which is a plane perpendicular to the axis Ax. In the case of this configuration, the internal member 10 is easily produced by molding.

As shown in FIG. 6E, in the ventilation component 1f, a plurality of the protruding portions 10p is arranged on one protection wall 31n. For example, around the axis Ax, a pair of the protruding portions 10p is arranged to be in contact with the protection wall 31n. This configuration makes it even less likely that the axis Ax of the internal member 10 is oblique to the axis of the external member 30 and that the external member 30 slips off the internal member 10.

As shown in FIG. 6F, in the ventilation component 1g, the protruding portion 10p has, for example, a semicircular outline in a cross-sectional view showing a cross section which is a plane perpendicular to the axis Ax. In this case as well, the internal member 10 is easily produced by molding.

As shown in FIG. 6G, in the ventilation component 1h, the protruding portion 10p has, for example, a triangular outline in a cross-sectional view showing a cross section which is a plane perpendicular to the axis Ax. In this case as well, the internal member 10 is easily produced by molding.

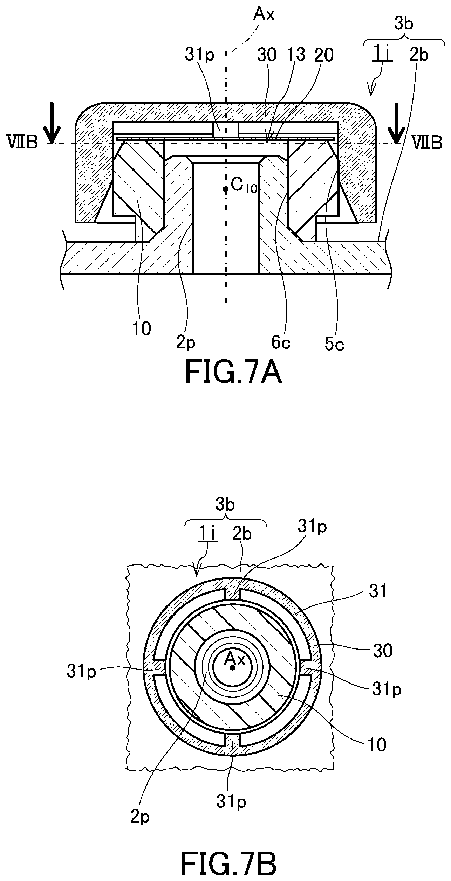

The ventilation component 1a may be modified to a ventilation component 1i shown in FIGS. 7A and 7B. The ventilation component 1i is configured in the same manner as the ventilation component 1a, unless otherwise described. The components of the ventilation component 1i that are the same as or correspond to those of the ventilation component 1a are denoted by the same reference characters, and detailed descriptions of such components are omitted. The description given for the ventilation component 1a can apply to the ventilation component 1i, unless there is technical inconsistency.

As shown in FIGS. 7A and 7B, in the ventilation component 1i, the external member 30 includes, for example, four protruding portions 31p around the axis Ax of the internal member 10. The four protruding portions 31p are placed around the axis Ax at regular intervals. The four protruding portions 31p protrude toward the axis Ax from the inner circumferential surface of the side wall 31 being annular. The first contact portion 5c is arranged away from the one opening 13 in the axial direction of the internal member 10. A portion of the outer circumferential surface of the internal member 10 has a taper surface, the portion being in contact with the one opening 13. In the case of this configuration, the ventilation component 1i is likely to have a simple configuration.

For example, a ventilation structure 3b can be provided using the ventilation component 1i. In the ventilation structure 3b, the ventilation component 1i is attached to the projection 2p of a housing 2b. The housing 2b is configured in the same manner as the housing 2a, except for the absence of the groove 2m. In the ventilation structure 3b, a space between the protruding portions 31p around the axis Ax functions as a ventilation path.

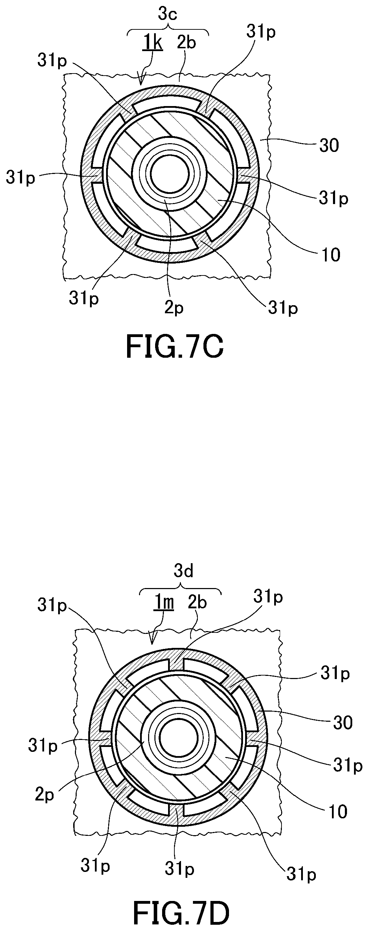

The ventilation component 1i may be modified to a ventilation component 1k shown in FIG. 7C and a ventilation component 1m shown in FIG. 7D. The ventilation components 1k and 1m are configured in the same manner as the ventilation component 1i, unless otherwise described. The components of the ventilation components 1k and 1m that are the same as or correspond to those of the ventilation component 1i are denoted by the same reference characters, and detailed descriptions of such components are omitted. The descriptions given for the ventilation components 1a and 1i can apply to the ventilation components 1k and 1m, unless there is technical inconsistency.

As shown in FIG. 7C, in the ventilation component 1k, the external member 30 includes six protruding portions 31p around the axis Ax of the internal member 10. A ventilation structure 3c can be provided by assembling the ventilation component 1k to the housing 2b. As shown in FIG. 7D, in the ventilation component 1m, the external member 30 includes eight protruding portions 31p around the axis Ax of the internal member 10. A ventilation structure 3d can be provided by assembling the ventilation component 1m to the housing 2b. The ventilation component 1i may be modified such that the number of protruding portions 31p of the external member 30 is an integer of two or greater except four, six, and eight.

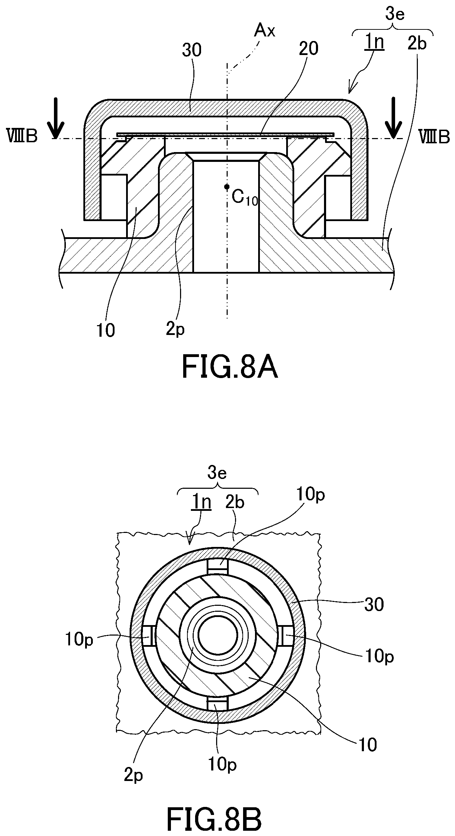

The ventilation component 1a may be modified to a ventilation component in as shown in FIGS. 8A and 8B. The ventilation component 1n is configured in the same manner as the ventilation component 1a, unless otherwise described. The components of the ventilation component 1n that are the same as or correspond to those of the ventilation component 1a are denoted by the same reference characters, and detailed descriptions of such components are omitted. The description given for the ventilation component 1a can apply to the ventilation component 1n, unless there is technical inconsistency.

In the ventilation component 1n, the internal member 10 includes, for example, four protruding portions 10p around the axis Ax of the internal member 10. The four protruding portions 10p are placed around the axis Ax at regular intervals. The four protruding portions 10p are in contact with the inner circumferential surface of the side wall 31 being annular to form the first contact portion 5c. In the ventilation component 1n, the first contact portion 5c is arranged away from the one opening 13 in the axial direction of the internal member 10. The outer circumferential surface of the internal member 10 has a taper surface between the first contact portion 5c and the one opening 13 in the axial direction of the internal member 10. In the case of this configuration, the ventilation component 1n is likely to have a simple configuration.

For example, a ventilation structure 3e can be provided using the ventilation component 1n. In the ventilation structure 3e, the ventilation component 1n is attached to the projection 2p of the housing 2b. In the ventilation structure 3e, a space between the protruding portions 10p around the axis Ax functions as a ventilation path.

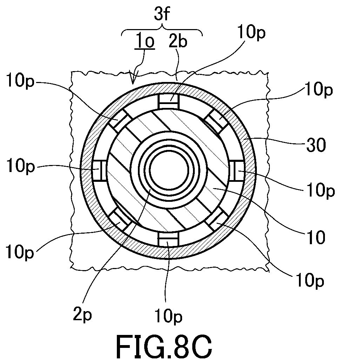

The ventilation component 1n may be modified to a ventilation component 1o as shown in FIG. 8C. The ventilation component 1o is configured in the same manner as the ventilation component 1n, unless otherwise described. The components of the ventilation component 1o that are the same as or correspond to those of the ventilation component 1n are denoted by the same reference characters, and detailed descriptions of such components are omitted. The description given for the ventilation components 1a and 1n can apply to the ventilation component 1o, unless there is technical inconsistency.

As shown in FIG. 8C, in the ventilation component 1o, the internal member 10 includes eight protruding portions 10p around the axis Ax of the internal member 10. A ventilation structure 3f can be provided by assembling the ventilation component 1o to the housing 2b. The ventilation component 1n may be modified such that the number of protruding portions 31p of the external member 30 is an integer of two or greater except four and eight.

### EXAMPLES

The present invention will be hereinafter described in more detail by examples. The present invention is not limited to the following examples.

### <Example 1>

A ventilation component according to Example 1 configured in the same manner as the ventilation component 1a was produced. A dimension of the ventilation component according to Example 1 in the axial direction was approximately 7 mm. A length of the internal member of the ventilation component according to Example 1 in the axial direction was 5 mm. The inner diameter of the internal member of the ventilation component was 7.4 mm. The outer diameter D₁₀ of a portion of the internal member was 9.2 mm, the portion forming a contact portion between the internal member and the external member. The diameter D₃₀ of the inscribed circle inscribed in a portion of the external member was 9 mm, the portion forming the contact portion. The external member of the ventilation component according to Example 1 included four protruding portions forming the contact portion. On a plane perpendicular to the axis Ax of the internal member, a pair of straight lines connecting each of two ends of the protruding portion and the axis Ax of the internal member made an angle θ of 11° or less, the ends being defined around the axis Ax. The ventilation component was attached to a housing A including a cylindrical projection having a height of 3.7 mm such that the ventilation component fully covered the projection. To accomplish the attachment, the projection was inserted into the internal member. The outer diameter of the projection of the housing A was 8 mm, and the outer circumferential surface of the top end of the projection was arranged to have a curvature radius of 0.5 mm. The ventilation structure according to Example 1 was obtained in this manner.

### <Example 2>

The ventilation component according to Example 1 was attached to a housing B including a cylindrical projection having a height of 3.7 mm such that the ventilation component fully covered the projection. To accomplish the attachment, the projection was inserted into the internal member. The outer diameter of the projection of the housing B was 8.4 mm, and the outer circumferential surface of the top end of the projection was arranged to have a curvature radius of 0.5 mm. The ventilation structure according to Example 2 was obtained in this manner.

### <Comparative Example 1>

A ventilation component according to Comparative Example 1 was produced in the same manner as in Example 1, except for the absence of the four protruding portions. The outer diameter D₁₀ of a portion of the internal member was 10.6 mm, the portion forming a contact portion between the internal member and the external member. The diameter D₃₀ of the inscribed circle inscribed in a portion of the external member was 10 mm, the portion forming the contact portion. A ventilation structure according to Comparative Example 1 was obtained by attaching the ventilation component according to Comparative Example 1 to the housing A in the same manner as in Example 1, except that the ventilation component according to Comparative Example 1 was used.

### <Comparative Example 2>

A ventilation structure according to Comparative Example 2 was obtained by attaching the ventilation component according to Comparative Example 1 to the housing B in the same manner as in Example 2, except that the ventilation component according to Comparative Example 1 was used.

### (Thermal shock test)

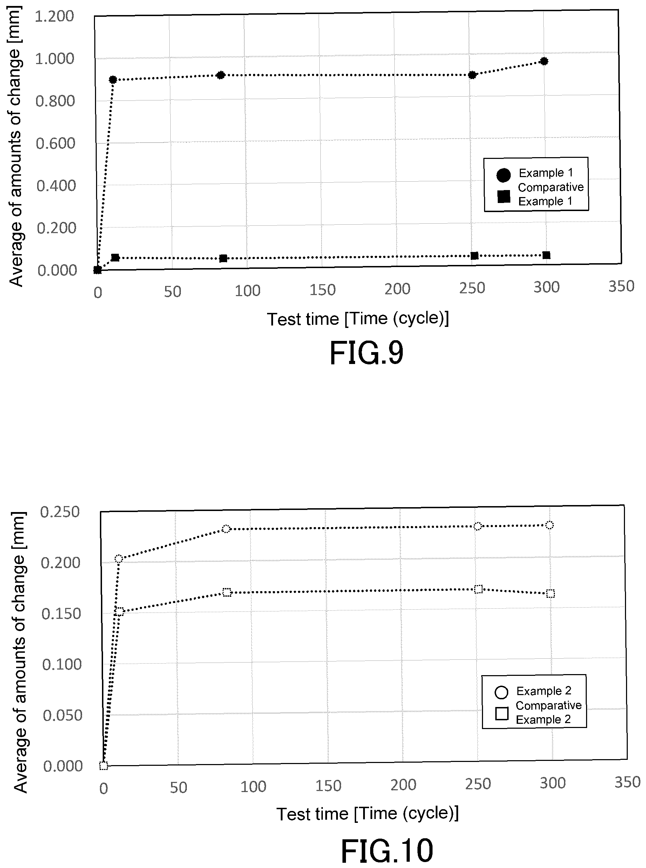

Twelve of each of the ventilation structure according to Example 1, the ventilation structure according to Example 2, the ventilation structure according to Comparative Example 1, and the ventilation structure according to Comparative Example 2 were prepared. A thermal shock test was performed by varying an environmental temperature of each ventilation structure in the range of -40°C to 125°C. The environmental temperature of each ventilation structure was adjusted so that one cycle of temperature variation would occur over one hour. In each cycle of temperature variation, the environmental temperature of the ventilation structure varied from 125°C to -40°C and then back to 125°C. In the thermal shock test, 300 cycles of the temperature variation occurred over 300 hours. The distance from a root of the projection to a top of the ventilation component was measured at a given timing during the thermal shock test. The distance from the root of the projection to the top of the ventilation component before the start of the thermal shock test was subtracted from the measured value to determine an amount of change for each ventilation structure. Then, an average of the amounts of change for the 12 ventilation structures was calculated. FIG. 9 shows a relation between the average of the amounts of change for the ventilation structures according to Example 1 and Comparative Example 1 and the test time. FIG. 10 shows a relation between the average of the amounts of change for the ventilation structures according to Example 2 and Comparative Example 2 and the test time.

As shown in FIGS. 9 and 10, the average of the amounts of change was small for the ventilation structures according to Examples 1 and 2 including the ventilation component according to Example 1, compared to the ventilation structures according to Comparative Examples 1 and 2 including the ventilation component according to Comparative Example 1. It is understood that the ventilation component according to Example 1 is not likely to move away from a projection of a housing after attached to the projection, compared to the ventilation component according to Comparative Example 1.

A first aspect of the present invention provides a ventilation component including:
an internal member including an elastic material and having an open tubular structure;
a gas-permeable membrane covering one opening of the internal member; and
an external member having a closed tubular structure, wherein
the internal member is fixed to the external member such that the internal member is inserted inside the external member and that a portion of an outer circumferential surface of the internal member is elastically deformed to form a first contact portion with a portion of an inner circumferential surface of the external member,
the ventilation component is capable of being fixed to a projection of a housing such that the projection is inserted inside the internal member through the other opening of the internal member and that an inner circumferential surface of the internal member is elastically deformed to form a second contact portion with an outer circumferential surface of the projection, the projection tubularly protruding from an outer surface of the housing toward an edge of a ventilation opening allowing communication between an inner space of the housing and an outer space of the housing,
the first contact portion is placed between a center of a portion of the internal member and the one opening, the center being defined in an axial direction of the internal member, the portion overlapping the external member in the axial direction,
an inner diameter of the external member is larger than an outer diameter of the internal member between the first contact portion and the other opening in the axial direction of the internal member,
a combination of the internal member and the external member includes a protruding portion arranged on the inner circumferential surface of the external member or the outer circumferential surface of the internal member, the protruding portion forming the first contact portion, and
around an axis of the internal member, a gap is present by the protruding portion and between the inner circumferential surface of the external member and the outer circumferential surface of the internal member.

A second aspect of the present invention provides the ventilation component according to the first aspect, wherein on a plane perpendicular to the axis of the internal member, a pair of straight lines connecting each of two ends of the protruding portion and the axis of the internal member makes an angle of 20° or smaller, the ends being defined around the axis.

A third aspect of the present invention provides the ventilation component according to the first or second aspect, wherein the protruding portion is arranged on the inner circumferential surface of the external member.

A fourth aspect of the present invention provides the ventilation component according to the first or second aspect, wherein the protruding portion is arranged on the outer circumferential surface of the internal member.

A fifth aspect of the present invention provides the ventilation component according to any one of the first to fourth aspects, wherein the internal member includes a central protruding portion arranged on the outer circumferential surface of the internal member at a position closer to the other opening than the first contact portion in the axial direction of the internal member, the central protruding portion protruding toward a direction perpendicular to the axial direction of the internal member.

A sixth aspect of the present invention provides the ventilation component according to the fifth aspect, wherein
the external member includes: an outermost edge defined in the direction perpendicular to the axis of the internal member; and a protection wall extending in a direction parallel to the axis at a position closer to the axis than the outermost edge when viewed in plan along the axis, the protection wall protecting the first contact portion, and
the protection wall overlaps the central protruding portion in the direction perpendicular to the axis.

A seventh aspect of the present disclosure provides the ventilation component according to the fifth or sixth aspect, wherein the external member includes a hooking portion arranged on the inner circumferential surface of the external member, the hooking portion hooking the central protruding portion.

An eighth aspect of the present invention provides the ventilation component according to any one of the first to seventh aspects, wherein the external member includes a ventilation hole overlapping at least a portion of the first contact portion in the axial direction of the internal member.

A ninth aspect of the present disclosure provides a ventilation structure including:
a housing;
an internal member including an elastic material and having an open tubular structure;
a gas-permeable membrane covering one opening of the internal member; and
an external member having a closed tubular structure, wherein
the internal member is fixed to the external member such that the internal member is inserted inside the external member and that a portion of an outer circumferential surface of the internal member is elastically deformed to form a first contact portion with a portion of an inner circumferential surface of the external member,
the housing includes a projection tubularly protruding from an outer surface of the housing toward an edge of a ventilation opening allowing communication between an inner space of the housing and an outer space of the housing,
the internal member is fixed to the projection such that the projection is inserted inside the internal member through the other opening of the internal member and that an inner circumferential surface of the internal member is elastically deformed to form a second contact portion with an outer circumferential surface of the projection,
the first contact portion is placed between a center of a portion of the internal member and the one opening, the center being defined in an axial direction of the internal member, the portion overlapping the external member in the axial direction,
an inner diameter of the external member is larger than an outer diameter of the internal member between the first contact portion and the other opening in the axial direction of the internal member,
a combination of the internal member and the external member includes a protruding portion arranged on the inner circumferential surface of the external member or the outer circumferential surface of the internal member, the protruding portion forming the first contact portion, and
around an axis of the internal member, a gap is present by the protruding portion and between the inner circumferential surface of the external member and the outer circumferential surface of the internal member.

## Claims

1. A ventilation component comprising:
an internal member including an elastic material and having an open tubular structure;
a gas-permeable membrane covering one opening of the internal member; and
an external member having a closed tubular structure, wherein
the internal member is fixed to the external member such that the internal member is inserted inside the external member and that a portion of an outer circumferential surface of the internal member is elastically deformed to form a first contact portion with a portion of an inner circumferential surface of the external member,
the ventilation component is capable of being fixed to a projection of a housing such that the projection is inserted inside the internal member through the other opening of the internal member and that an inner circumferential surface of the internal member is elastically deformed to form a second contact portion with an outer circumferential surface of the projection, the projection tubularly protruding from an outer surface of the housing toward an edge of a ventilation opening allowing communication between an inner space of the housing and an outer space of the housing,
the first contact portion is placed between a center of a portion of the internal member and the one opening, the center being defined in an axial direction of the internal member, the portion overlapping the external member in the axial direction,
an inner diameter of the external member is larger than an outer diameter of the internal member between the first contact portion and the other opening in the axial direction of the internal member,
a combination of the internal member and the external member includes a protruding portion arranged on the inner circumferential surface of the external member or the outer circumferential surface of the internal member, the protruding portion forming the first contact portion, and
around an axis of the internal member, a gap is present by the protruding portion and between the inner circumferential surface of the external member and the outer circumferential surface of the internal member.

2. The ventilation component according to claim 1, wherein on a plane perpendicular to the axis of the internal member, a pair of straight lines connecting each of two ends of the protruding portion and the axis of the internal member makes an angle of 20° or smaller, the ends being defined around the axis.

3. The ventilation component according to claim 1, wherein the protruding portion is arranged on the inner circumferential surface of the external member.

4. The ventilation component according to claim 1, wherein the protruding portion is arranged on the outer circumferential surface of the internal member.

5. The ventilation component according to claim 1, wherein the internal member includes a central protruding portion arranged on the outer circumferential surface of the internal member at a position closer to the other opening than the first contact portion in the axial direction of the internal member, the central protruding portion protruding toward a direction perpendicular to the axial direction of the internal member.

6. The ventilation component according to claim 5, wherein
the external member includes: an outermost edge defined in the direction perpendicular to the axis of the internal member; and a protection wall extending in a direction parallel to the axis at a position closer to the axis than the outermost edge when viewed in plan along the axis, the protection wall protecting the first contact portion, and
the protection wall overlaps the central protruding portion in the direction perpendicular to the axis.

7. The ventilation component according to claim 5, wherein the external member includes a hooking portion arranged on the inner circumferential surface of the external member, the hooking portion hooking the central protruding portion.

8. The ventilation component according to claim 1, wherein the external member includes a ventilation hole overlapping at least a portion of the first contact portion in the axial direction of the internal member.

9. A ventilation structure comprising:
a housing;
an internal member including an elastic material and having an open tubular structure;
a gas-permeable membrane covering one opening of the internal member; and
an external member having a closed tubular structure, wherein
the internal member is fixed to the external member such that the internal member is inserted inside the external member and that a portion of an outer circumferential surface of the internal member is elastically deformed to form a first contact portion with a portion of an inner circumferential surface of the external member,
the housing includes a projection tubularly protruding from an outer surface of the housing toward an edge of a ventilation opening allowing communication between an inner space of the housing and an outer space of the housing,
the internal member is fixed to the projection such that the projection is inserted inside the internal member through the other opening of the internal member and that an inner circumferential surface of the internal member is elastically deformed to form a second contact portion with an outer circumferential surface of the projection,
the first contact portion is placed between a center of a portion of the internal member and the one opening, the center being defined in an axial direction of the internal member, the portion overlapping the external member in the axial direction,
an inner diameter of the external member is larger than an outer diameter of the internal member between the first contact portion and the other opening in the axial direction of the internal member,
a combination of the internal member and the external member includes a protruding portion arranged on the inner circumferential surface of the external member or the outer circumferential surface of the internal member, the protruding portion forming the first contact portion, and
around an axis of the internal member, a gap is present by the protruding portion and between the inner circumferential surface of the external member and the outer circumferential surface of the internal member.
